# EUROPEAN PATENT APPLICATION

(11) **EP 2 023 384 A1**
(43) Date of publication of application: **11.02.2009**
(21) Application number: 07743857.0
(22) Date of filing: 22.05.2007
(51) Int. Cl.: H01L 21/60, H01L 21/3205, H01L 23/52

(54) **ELECTRONIC COMPONENT, SEMICONDUCTOR PACKAGE AND ELECTRONIC DEVICE**

(30) Priority: 29.05.2006 JP 2006148207; 19.01.2007 JP 2007010094
(71) Applicant: NEC Corporation, Minato-ku Tokyo 108-8001 (JP); NEC Electronics Corporation, Kawasaki-shi, Kanagawa 211-8668 (JP)
(72) Inventor: SOGAWA, Yoshimichi, Minato-ku, Tokyo 108-8001 (JP); YAMAZAKI, Takao, Minato-ku, Tokyo 108-8001 (JP); TAKAHASHI, Nobuaki, Kawasaki-shi, Kanagawa 211-8668 (JP)
(74) Representative: Wenzel & Kalkoff
(86) International application number: PCT/JP2007/060423
(87) International publication number: WO 2007/138922

(57) **Abstract**

In a conventional UBM made of, for example, Cu, Ni, or NiP, there has been a problem that when an electronic component is held in high-temperature conditions for an extended period, the barrier characteristic of the UBM is lost and the bonding strength decreases due to formation of a brittle alloy layer at a bonding interface. The present invention improves the problem of decrease in long-term connection reliability of a solder connection portion after storage at high temperatures. The electronic component comprises an electrode pad formed on a substrate or a semiconductor element and a barrier metal layer formed to cover the electrode pad and the barrier metal layer comprises a CuNi alloy layer on the side opposite the side in contact with the electrode pad, the CuNi alloy layer containing 15 to 60at% of Cu and 40 to 85at% of Ni.

## Description

### Technical Field

The present invention relates to an electronic component, a semiconductor package, and an electronic device which comprise a barrier metal layer on an electrode pad.

### Background Art

In association with higher performance of electronic devices in recent years, there is an increasing need for higher density mounting in semiconductor packages. In an example of a method for providing such a high-density semiconductor package, solder bumps are formed on electrode pads on a surface of an LSI chip, and the LSI chip is joined with an interposer substrate or a mother board, such as a build-up substrate and a flexible substrate, or another LSI chip by using flip-chip connection.
In general, when a solder bump made of, for example, SnPb, SnAg, SnCu, SnAgCu, SnZn, SnZnBi, and Snln, is used in flip-chip connection, Sn, which the solder bump is primarily made of, diffuses into the electrode pad and wiring, made of Al or Cu, of an LSI chip during a reflow and bond process, a repair process, or when the product is used at high temperatures, resulting in electric problems in some cases.

To prevent the diffusion, a UBM (Under Bump Metal) (barrier metal layer) that is highly effective in preventing solder diffusion is used between the electrode pad and the solder bump. As a typical example of the UBM having the barrier capability, Ni formed by electrolytic plating or NiP formed by electroless plating is often used. This is because Ni less likely diffuses than Sn, so that the barrier characteristic can be maintained even after storage at high temperatures.

However, since Ni does not have good wettability (adhesiveness), Au having good wettability with solder is typically formed on the surface of the Ni or NiP by electrolytic plating or displacement plating to ensure wettability with solder.

In recent years, CSP (Chip Size/Scale Package) and BGA (Ball Grid Array) have been increasingly used to mount semiconductor packages at high density on a printed wiring substrate, and solder bumps are used for secondary connection in the semiconductor packages. In these cases, an interposer substrate and a printed wiring substrate typically use Cu wiring and Cu electrodes. To prevent electric problems resulting from diffusion of the constituents in the solder into the Cu wiring due to the heat generated in a reflowing operation, a UBM formed of an Ni film on which an Au film is formed by electrolytic plating or an NiP film on which an Au film is formed by electroless plating is often provided between the Cu electrode pad and the solder bump.

In the connection structure of related art, when copper having a thickness on the order of 1 µm is used as an intermediate metal layer between the electrode pad and the solder bump, the majority of the copper diffuses into the solder bump during a reflowing operation, disadvantageously resulting in occurrence of the problem of decrease in adhesiveness between the intermediate metal layer and the solder bump, and hence degradation in reliability. Further, when nickel, which is a magnetic material, is formed in the intermediate metal layer by sputtering or other methods, the problem of reduction of efficient working occurs. There have been attempts to solve the above problems by using a UBM made of a special alloy.

Examples of such a UBM may include Ni, NiP, large film-thickness Cu, and CuNi as described in Japanese Patent Laid-Open No. 06-084919.

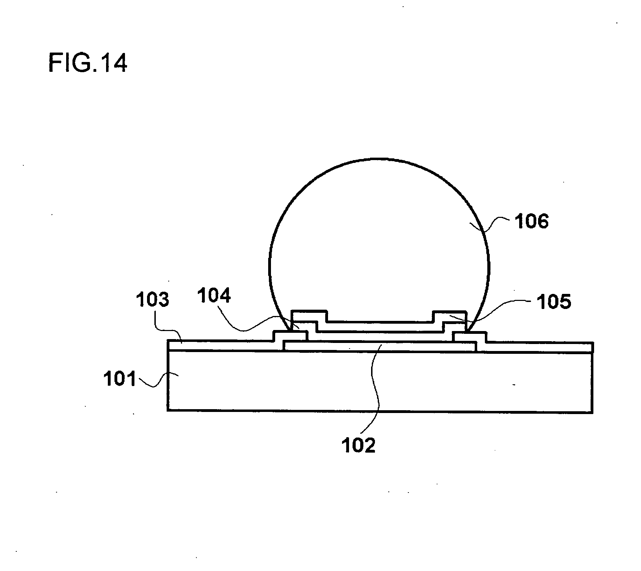

Figure 14 is a cross-sectional view of a structure in which a barrier metal layer (UBM) made of a CuNi alloy connects an electrode pad to a solder bump. In the connection structure shown in Figure 14, a barrier metal layer (UBM) 105 uses a CuNi alloy. Such a UBM 105 not only prevents decrease in adhesiveness between an intermediate metal layer 104 and a solder bump 106 but also increases the film uniformity, film strength, film forming efficiency, and reliability and reduces the cost as compared to those obtained in typical vacuum vapor deposition.

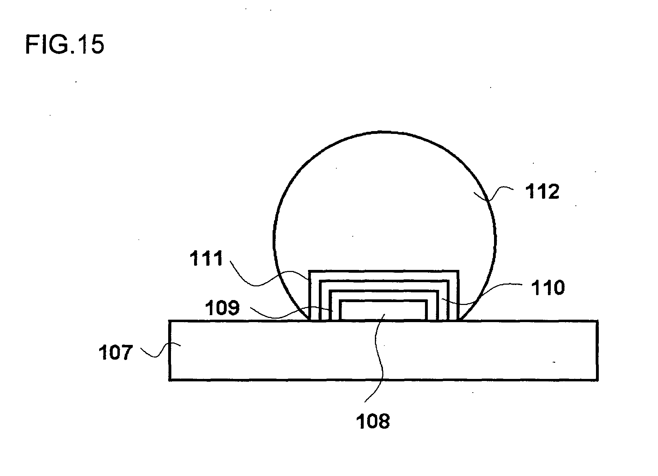

Japanese Patent Laid-Open No. 2002-203925 proposes a connection structure in which an Au film is provided on an NiP film as the UBM or a connection structure in which an Au film is provided on an NiCuP film. Figure 15 is a cross-sectional view of a structure in which a UBM made of an NiP alloy or an NiCuP alloy connects an electrode pad to a solder bump. In the connection structure, an NiP layer (or an NiCuP layer) 109 is formed on a metal wiring 108, and a high P-Ni layer (or an NiCu layer) 110 and an NiSn alloy layer (or an NiCuSn alloy layer) 111 are further formed to connect the metal wiring 108 to a solder bump 112. Such a structure that prevents a Kirkendall void from being generated can enhance the adhesion strength.

### Disclosure of the Invention

### (Problems in related art)

(a) In a conventional LSI chip and wiring substrate, such as a printed substrate and a flexible substrate, a UBM in which an Au film is provided on an electrolytic Ni film or a UBM in which an Au film is provided on an electroless NiP film is formed on an Al or Cu electrode pad. The UBM is used to connect the electrode pad to a solder bump made of, for example, SnAg, SnAgCu, SnCu, and SnPb. When such a UBM is used, however, an Ni-rich alloy, such as needle-shaped Ni₃Sn₄ or (Ni, Cu)₃Sn₄, is likely formed at the interface between the solder bump and the barrier metal layer (UBM). In the connection structure in which such an Ni-rich alloy is formed, the Ni-rich alloy layer is often fractured when a stress or impact is applied to the bonding interface and hence the bonding strength decreases. In particular, when the solder inherently contains no Cu at all or when the amount of Cu in the solder is small, the alloy layer increasingly tends to fracture and hence the bonding strength decreases.

In addition to those described above, other electronic components are conceivable in which the content of Cu in the solder is relatively high (approximately 0.5 to 1 %) and a Cu-rich alloy layer made of, for example, Cu₆Sn₅, (Cu, Ni)₆Sn₅, Cu₃Sn, (Cu, Ni)₃Sn is formed in an alloy layer at the interface between the UBM and the solder. However, even in this case as well, the Cu in the solder bump is depleted when the electronic component is used in a high-temperature environment for an extended period. As a result, the content of Cu in the interface between the UBM and the solder bump decreases, and an Ni-rich (Ni, Cu)₃Sn₄ or Ni₃Sn₄ intermetallic compound is gradually formed, resulting in an occurrence of phenomenon which ingenerates a fracture in the portion where such an intermetallic compound is formed and hence decreases the bonding strength. That is, the bonding strength decrease phenomenon occurs when a predetermined composition of the UBM causes almost all the Cu-rich alloy at the connection interface to be converted into an Ni-rich alloy and the Cu-rich alloy to be inexistent.

To prevent the above problem, it is necessary to employ a structure that prevents the interface between the UBM and the solder bump from being covered only with a needle-shaped Ni-rich alloy. The Ni-rich alloy used in the present invention means a Cu/Ni-containing alloy formed in the interface between the UBM and the solder and having a Ni content higher than the content of Cu, that is, Ni/Cu>1 (based on the number of atoms). Conversely, an alloy that satisfied Ni/Cu≤1 (based on the number of atoms) is defined as a Cu-rich alloy.

(b) In a high-density LSI chip and wiring substrate comprising a large number of electrode pads in a small area, an electroless NiP film on which an Au film capable of forming a UBM at a low cost is formed is often used even when no electric plating lead wire or seed layer is present as the UBM material. However, in the NiP film on which an Au film formed by electroless plating is formed, when the NiP film is bonded to a solder bump, Ni in the UBM diffuses into the solder bump, and a P-rich layer, such as a P-rich CuNiP layer and a P-rich NiP layer (a layer primarily made of Ni₃P), is formed at the interface between the solder bump and the UBM in some cases. Cracks may occur in the P-rich NiP layer, which is particularly hard but brittle among the above layers, and when a thermal stress impact, a drop impact, or other impacts are applied, the problem of the easier P-rich layer fracture occurs. It is therefore necessary to employ a structure that suppresses the formation of a P-rich NiP layer or other layers at the interface between the UBM and the solder bump in order to prevent the bonding strength from decreasing.

(c) Further, when electrode pads in an LSI are made of Al, a sufficient bonding strength between the solder bump and Al is not provided, and a UBM as an intermediate layer is therefore used. In this case, when the barrier metal layer (UBM) used is made of a material having a poor barrier characteristic, such as Cu, and used in high-temperature conditions, the UBM is completely melted, resulting in the loss of the barrier characteristic. Accordingly, there has been a problem that Al comes into direct contact with the solder bump, and the strength of the interface between the Al and the solder bump significantly decreases.

Further, in a printed substrate, a flexible substrate, and other substrates, no UBM is used but a solder bump is directly connected to a Cu electrode. Cu, however, significantly likely diffuses into Sn by nature. The Cu in the electrode therefore diffuses into the solder bump during a double-side mounting process, a repair process, or when the substrate is used in a high-temperature environment for an extended period, and a break may occur in an Sn alloy portion that has penetrated into a Cu wiring. To prevent this in advance and provide an excellent long-term bonding reliability, it is again necessary to use a UBM having high bonding strength and excellent barrier characteristic between the Cu electrode and the solder bump.

Further, in a recent LSI, Al is replaced with Cu as the material of wiring and electrode pads in some cases. The thickness of the Cu film on the LSI is, however, typically significantly small, for example, approximately 1 µm. Therefore, there has been a problem that when the Cu film comes into contact with the solder bump in reflow or other operations, all the Cu in the electrode diffuses into the solder. To avoid such a problem, it is necessary to form a UBM having excellent barrier and bonding characteristics on the Cu electrode. As described above, it is also essential that a UBM must maintain its barrier characteristic even when stored in high-temperature conditions for an extended period.

(d) When a conventional Ni film on which an Au film is formed or a conventional NiP alloy UBM on which an Au film is formed is used, the Au used to improve the wettability of the UBM with solder in some cases forms a brittle SnAu alloy at the interface connected to the solder bump. This is because Au and Sn form a brittle intermetallic compound and hence when a stress or impact is applied, fracture starting at the AuSn alloy occurs. To avoid such a problem, it is desirable not to plate the UBM surface with Au. In reality, however, the Au plating is necessary because conventional UBM materials have poor wettability with solder to Ni. To suppress the formation of an AuSn alloy due to the use of Au plating, in practice, the thickness of the Au film is set to a small value. It has not been possible, however, to completely suppress the formation of a brittle AuSn alloy.

On the other hand, Japanese Patent Laid-Open Nos. 06-084919 and 2002-203925 report UBMs made of a CuNi alloy and a CuNiP alloy. However, regarding the problems described above in (a) to (d), when the composition of the UBM is not optimum, the initial bonding strength is sufficient, but the composition of the interface between the UBM and the solder bump changes after the structure has been exposed to a high-temperature environment as described above, and hence the bonding strength significantly decreases in some cases. In other words, the use of a UBM made of a CuNi alloy or a CuNiP alloy does not guarantee a sufficient solder bonding strength for an extended period across the whole composition range.

A UBM typically used in an LSI is subject to three reflowing operations: (1) when a solder bump is formed, (2) when the LSI is connected to an interposer substrate, and (3) when a semiconductor package is connected to a mother board. In consideration of a double-side mounting process, a repair process, and other processes, the UBM is subject to five or more reflow processes in total. When the heated LSI is used for an extended period, the heat applied to the portion where the UBM is bonded to the solder bump facilitates the change in composition in the interface between the UBM and the solder bump and hence further reduces the bonding strength. There is therefore a need for a UBM whose bonding strength does not decrease after being held at high temperatures.

According to the investigation conducted by the present inventor, the following factors are responsible for the decrease in bonding strength after the structure is held at high temperatures as described above. There is a need for a UBM that can solve the above problems.
(a) Formation and growth of an Ni-rich (Ni, Cu)₃Sn₄
(b) Generation and growth of a P-rich layer
(c) Contact of the solder bump with the electrode pad due to a completely melted UBM
(d) Decrease in bonding strength due to formation of an AuSn alloy

The present inventor has conducted extensive studies and found an optimum UBM composition at which the bonding strength does not decrease even after multiple reflow processes and use in a high-temperature environment for an extended period. That is, the present invention provides the following configurations to solve the above problems.

1. An electronic component comprising:
   an electrode pad formed on a substrate or a semiconductor element; and
   a barrier metal layer formed to cover the electrode pad,
wherein the barrier metal layer comprises a CuNi alloy layer containing 15 to 60at% of Cu and 40 to 85at% of Ni on the side opposite the electrode pad.

2. An electronic component comprising:
   an electrode pad formed on a substrate or a semiconductor element; and
   a barrier metal layer formed to cover the electrode pad,
   wherein the barrier metal layer comprises a CuNiP alloy layer containing 15at% or higher of Cu, 40at% or higher of Ni, and above 0at% and 25at% or lower of P on the side opposite the electrode pad.

3. An electronic component comprising:
   an electrode pad formed on a substrate or a semiconductor element; and
   a barrier metal layer formed to cover the electrode pad,
   wherein the barrier metal layer comprises a CuNiP alloy layer on the side opposite the electrode pad, the CuNiP alloy layer containing 44 to 60at% of Cu, 29 to 40at% of Ni, and 8 to 16at% of P with the content of Ni being at least 2.5 times the content of P.

4. A semiconductor package comprising:
   a plurality of electronic members formed of at least one of a substrate and a semiconductor element;
   an electrode pad formed on each of the electronic members;
   a barrier metal layer formed to cover the electrode pad;
   a CuNiSn alloy layer having an average Ni/Cu ratio of 2.3 or lower formed to cover the barrier metal layer; and
   a solder bump formed to electrically connect the electrode pads to each other formed on the different electronic members via the barrier metal layers and the CuNiSn alloy layers,
   wherein the barrier metal layer comprises a CuNi alloy layer that is in contact with the CuNiSn alloy layer, the CuNi alloy layer containing 15 to 60at% of Cu and 40 to 85at% of Ni.

5. A semiconductor package comprising:
   a plurality of electronic members formed of at least one of a substrate and a semiconductor element;
   an electrode pad formed on each of the electronic members;
   a barrier metal layer formed to cover the electrode pad;
   a CuNiSn alloy layer having an average Ni/Cu ratio of 2.3 or lower formed to cover the barrier metal layer;
   a P-containing P-rich layer formed between the barrier metal layer and the CuNiSn alloy layer; and
   a solder bump formed to electrically connect the electrode pads to each other formed on the different electronic members via the barrier metal layers, the CuNiSn alloy layers, and the P-rich layers,
   wherein the barrier metal layer comprises a CuNiP alloy layer that is in contact with the P-rich layer, the CuNiP alloy layer containing 15at% or higher of Cu, 40at% or higher of Ni, and above 0at% and 25at% or lower of P.

6. A semiconductor package comprising:
   a plurality of electronic members formed of at least one of a substrate and a semiconductor element;
   an electrode pad formed on each of the electronic members;
   a barrier metal layer formed to cover the electrode pad;
   a CuNiSn alloy layer having an average Ni/Cu ratio of 2.3 or lower formed to cover the barrier metal layer;
   a P-containing P-rich layer formed between the barrier metal layer and the CuNiSn alloy layer; and
   a solder bump formed to electrically connect the electrode pads to each other formed on the different electronic members via the barrier metal layers, the CuNiSn alloy layers, and the P-rich layers,
   wherein the barrier metal layer comprises a CuNiP alloy layer that is in contact with the P-rich layer, the CuNiP alloy layer containing 44 to 60at% of Cu, 29 to 40at% of Ni, and 8 to 16at% of P with the content of Ni being at least 2.5 times the content of P.
In the present specification, "at%" represents the percentage of the number of atoms and can also be described as "atomic%."
The "P-containing P-rich layer" described in the above "5" and "6" includes a first P-rich layer and a second P-rich layer.

That is, in an electronic component, a semiconductor package, and the like of the present invention, as the UBM (1) a CuNi alloy layer containing 15 to 60at% of Cu and 40 to 85at% of Ni, (2) a CuNiP alloy layer containing 15at% or higher of Cu, 40at% or higher of Ni, and above 0at% and 25at% or lower of P, or (3) a CuNiP alloy layer containing 44 to 60at% of Cu, 29 to 40at% of Ni, and 8 to 16at% of P with the content of Ni being at least 2.5 times the content of P is specifically used to connect the electrode pad to the solder bump.

The "Cu Sn alloy layer" is a layer automatically formed between the UBM and the solder bump by depositing a solder bump material on the UBM and then performing heat treatment. The UBM, CuNiSn alloy layer, P-rich layer, solder bump of the present invention can be clearly identified by using a SEM (Scanning Electron Microscope), or using a SEM and EDX (Energy Dispersive X-ray Analysis) in combination.

Any of the UBM compositions described in the above (1) to (3) can provide a connection portion that excels in long-term bonding reliability and solves the following four problems, which have been problematic in a UBM containing any of Ni, NiP, and Cu:
(a) Decrease in bonding strength due to growth of an Ni-rich intermetallic compound
(b) Decrease in bonding strength due to formation of a P-rich NiP or CuNiP layer
(c) Decrease in bonding strength due to loss of barrier characteristic
(d) Decrease in bonding strength due to formation of an AuSn alloy

When a UBM made of the CuNi alloy (1) according to the present invention is bonded to a solder bump containing Sn, Cu in the UBM preferentially diffuses into the solder bump as compared to Ni, whereby the concentration of Cu in the interface between the UBM and the solder bump becomes high, resulting in preventing the growth of a needle-shaped Ni-rich intermetallic compound (a) causing decrease in bonding strength. This effect is clearly exhibited when the content of Cu in the UBM is 15 to 60at%. When a UBM containing 15 to 60at% of Cu is used, the concentration of Cu in an alloy that constitutes the interface becomes sufficiently high, and hence the formation of an Ni-rich alloy can be suppressed.

Further, in a UBM made of the CuNiP alloy (2), the content of Cu is 15at% or higher, and in a UBM made of the CuNiP alloy (3), the content of Cu is 44 to 60at%. Such content of Cu can be said to be high levels. Therefore, in each of these UBMs as well, Cu in the UBM preferentially diffuses into the solder bump as compared to Ni, resulting in preventing the growth of a needle-shaped Ni-rich intermetallic compound (a) causing decrease in bonding strength.

When a UBM made of the CuNiP alloy (2) according to the present invention is used, the UBM contains 15at% or higher of Cu. In a UBM made of the CuNiP alloy (3), the content of Cu is 44 to 60at%. Interdiffusion between the UBM and the solder bump thus likely occurs in the above UBMs, as compared to a case when an NiP alloy containing no Cu is used. Therefore, when either of the above UBMs is bonded to a solder bump containing Sn, formation of a P-rich NiP or CuNiP layer can be significantly suppressed, although a P-rich NiSnP or NiCuSnP layer (b) formed at the interface becomes thick.

When the CuNi alloy layer (1) or the CuNiP alloy layer (2) of the present invention contains 40at% or higher of Ni, the barrier characteristic (c), which has been problematic in a UBM made of a CuNi alloy containing a small amount of Ni, can be significantly improved. When the content of Ni is lower than 40at%, the electrode pad may, depending on the composition of the UBM, come into direct contact with the solder bump after the structure has been held at high temperatures, and hence the bonding strength may significantly decrease. When the content of Ni is 40at% or higher, however, the barrier characteristic will not be lost or the bonding strength will not decrease after the structure undergoes reflowing or used in a high-temperature environment even in a case when the thickness of the UBM film is a practical value of 5 µm.

When a UBM made of the CuNiP alloy (3) of the present invention is used, a P-rich layer formed at the interface between the solder bump and the UBM suppresses interdiffusion between the solder bump and the UBM. Therefore, the barrier characteristic (c) in the UBM is improved, and connection reliability is ensured after the structure undergoes reflowing or is used in a high-temperature environment even when the content of Ni is 40at% or lower and the film thickness is 5 µm or smaller.

Further, in a conventional UBM made of Ni or an NiP alloy, wettability with solder was poor unless Au is plated on the surface. However, since the CuNi alloy layer (1) or the CuNiP alloy layer (2) or (3) according to the present invention contains Cu, which has excellent wettability with solder, the wettability with solder is better than that in Ni or an NiP alloy. Therefore, a solder bump can be readily bonded to an electrode pad without carrying out Au plating. The effect of Cu on improving wettability with solder is well maintained for a Cu content of 60at% or lower. Since no Au is plated and hence no brittle AuSn layer is formed in the structure according to the present invention when bonded to a solder bump, it is possible to completely eliminate the risk of bonding failure starting at the AuSn layer (d) and provide good connection reliability.

In the present invention, on an electrode pad is formed (1) a UBM made of a CuNi alloy containing 15 to 60at% of Cu and 40 to 85at% of Ni, (2) a UBM made of a CuNiP alloy containing 15at% or higher of Cu, 40at% or higher of Ni, and above 0at% and 25at% or lower of P, or (3) a UBM made of a CuNiP alloy containing 44 to 60at% of Cu, 29 to 40at% of Ni, and 8 to 16at% of P with the content of Ni (based on the number of atoms) being at least 2.5 times the content of P (based on the number of atoms).

In this way, when the UBM is bonded to a solder bump containing Sn, formation of an Ni-rich alloy and generation of a P-rich NiP or CuNiP layer can be suppressed while a high barrier characteristic is maintained at the bonding interface between the UBM and the solder bump. It is further possible to prevent decrease in bonding strength between the solder bump and the electrode pad due to formation of an AuSn alloy. As a result, there is provided a highly reliable electronic component whose solder bonding strength will decrease very little even after long-term use at high temperatures.

In the present invention, electrode pads are electrically connected to one or more substrates or semiconductor elements (electronic members). On each of the electrode pads is formed (1) a UBM formed of a CuNi alloy layer containing 15 to 60at% of Cu and 40 to 85at% of Ni, (2) a UBM formed of a CuNiP alloy layer containing 15at% or higher of Cu, 40at% or higher of Ni, and above 0at% and 25at% or lower of P, or (3) a UBM formed of a CuNiP alloy layer containing 44 to 60at% of Cu, 29 to 40at% of Ni, and 8 to 16at% of P with the content of Ni being at least 2.5 times the content of P.

When solder bumps containing Sn are formed to electrically connect two or more UBMs formed on the different electronic members, a CuNiSn alloy layer having an average Ni/Cu ratio of 2.3 or lower is formed between each pair of the UBMs and the solder bumps. As a result, generation of an Ni-rich CuNiSn alloy and a P-rich NiP or CuNiP layer can be suppressed while a high barrier characteristic is maintained. Further, relatively excellent wettability with solder can be achieved without carrying out Au plating, and no brittle AuSn alloy layer will be generated, whereby high bonding strength is provided. Accordingly, there is provided a highly reliable semiconductor package whose solder bonding strength will decrease very little even after long-term use at high temperatures.

### Brief Description of the Drawings

Figure 1 is a cross-sectional view of an exemplary electronic component of the present invention;
Figure 2 is a cross-sectional view of the exemplary electronic component of the present invention, in which a solder bump is formed on each UBM;
Figure 3 is an enlarged cross-sectional view of the exemplary electronic component of the present invention, in which a solder bump is formed on the UBM made of a CuNi alloy;
Figure 4 is an enlarged cross-sectional view of the exemplary electronic component of the present invention, in which a solder bump is formed on the UBM made of a CuNiP alloy;
Figure 5 shows the relationship between the percentage of Cu content in a UBM and the average Ni/Cu ratio in a CuNiSn alloy layer;
Figure 6 is a cross-sectional view of a connection portion where a conventional UBM made of an NiP alloy is bonded to an SnAgCu solder bump;
Figure 7 is a cross-sectional view of an example of the connection portion where a UBM made of a CuNiP alloy of the present invention is bonded to an SnAgCu solder bump;
Figure 8 shows the relationship between the percentage of Ni content in a UBM and the thickness of the melted UBM film;
Figure 9 is a phase diagram showing an optimum composition range of a UBM of the present invention;
Figure 10 is a cross-sectional view of an exemplary electronic component of the present invention, in which an intermediate layer is formed between a UBM and an electrode pad;
Figure 11 is a cross-sectional view of an exemplary electronic component of the present invention, in which an intermediate layer is formed between a UBM made of a CuNi alloy and an electrode pad;
Figure 12 is a cross-sectional view of an exemplary electronic component of the present invention, in which an intermediate layer is formed between a UBM made of a CuNiP alloy and an electrode pad;
Figure 13 shows an exemplary semiconductor package of the present invention;
Figure 14 is a cross-sectional view of a connection portion where a conventional UBM made of a CuNi alloy is connected to a solder bump;
Figure 15 is a cross-sectional view of a connection portion where a conventional UBM made of an NiP alloy or a CuNiP alloy is connected to a solder bump; and
Figure 16 is a phase diagram showing an optimum composition range of a UBM of the present invention.

### Description of Symbols

1: Electronic component
2: Electrode pad
3: UBM
4: Passivation
5: Solder bump
6: CuNiSn alloy layer
7: First P-rich layer
8: Second P-rich layer
9: Intermediate layer
21: Mother board
22: Interposer substrate
23: Semiconductor chip
24: Solder bump for primary connection
25: Solder bump for secondary connection
26: Electrode pad of printed substrate
27: Electrode pad for secondary connection of interposer substrate
28: Electrode pad for primary connection of interposer substrate
29: Electrode pad of semiconductor chip
30: UBM on electrode pad of printed substrate
31: UBM on electrode pad for secondary connection of interposer substrate
32: UBM on electrode pad for primary connection of interposer substrate
33: UBM on electrode pad for semiconductor chip
34: Underfill resin
35: Mold resin
101: Semiconductor chip
102: Metal electrode (aluminum electrode) on face-down bonding surface of semiconductor chip
103: SiN insulating film
104: Titanium film (one layer in intermediate metal layers)
105: Intermediate metal layer formed of copper-nickel alloy film
106: Solder bump
107: Ceramic (insulating) substrate
108: Wiring (metal pattern)
109: NiP (or NiCuP) layer
110: High P-NiP (or NiCuP) layer
111: NiSn (or NiCuSn) layer
112: Solder bump

### Best Mode for Carrying Out the Invention

The present invention will be described below in more detail based on embodiments of the present invention with reference to the drawings.

### (First Embodiment)

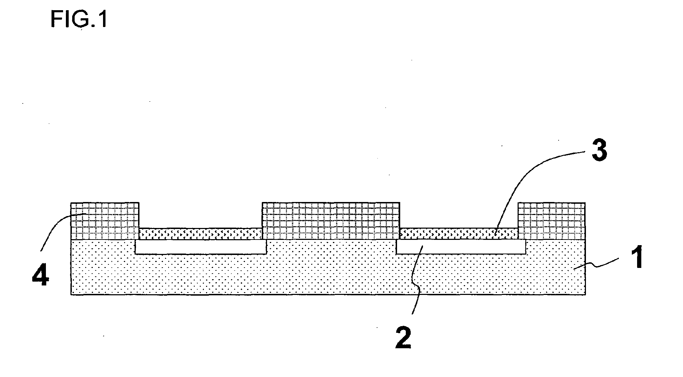

As shown in Figure 1, in an example of an electronic component 1 according to the present invention, a UBM (barrier metal layer) 3 is formed on an electrode pad 2 made of, for example, Al, Cu, and Ag formed on a substrate or a semiconductor element. The electrode pad is electrically connected to a wiring in the substrate or the semiconductor element.

The UBM 3 has any of the following alloy layers formed at least on the side opposite the side in contact with the electrode pad: (1) a CuNi alloy layer containing 15 to 60at% of Cu and 40 to 85at% of Ni, (2) a CuNiP alloy layer containing 15at% or higher of Cu, 40at% or higher of Ni, and above 0at% and 25at% or lower of P, or (3) a CuNiP alloy layer containing 44 to 60at% of Cu, 29 to 40at% of Ni, and 8 to 16at% of P with the content of Ni (based on the number of atoms) being at least 2.5 times the content of P (based on the number of atoms).

That is, the CuNiP alloy layer (2) needs to contain 15at% or higher of Cu and 40at% or higher of Ni. For example, when the content of P is x (at%), the Cu/Ni composition contains Cu higher than or equal to 15at% but lower than or equal to (60-x)at% and Ni higher than or equal to 40at% but lower than or equal to (85-x)at% (contains Cu, Ni, and P with the numbers of atoms of the elements being Cu:Ni:P=15 to 60:40 to 85:0 (exclusive) to 25 (inclusive)).

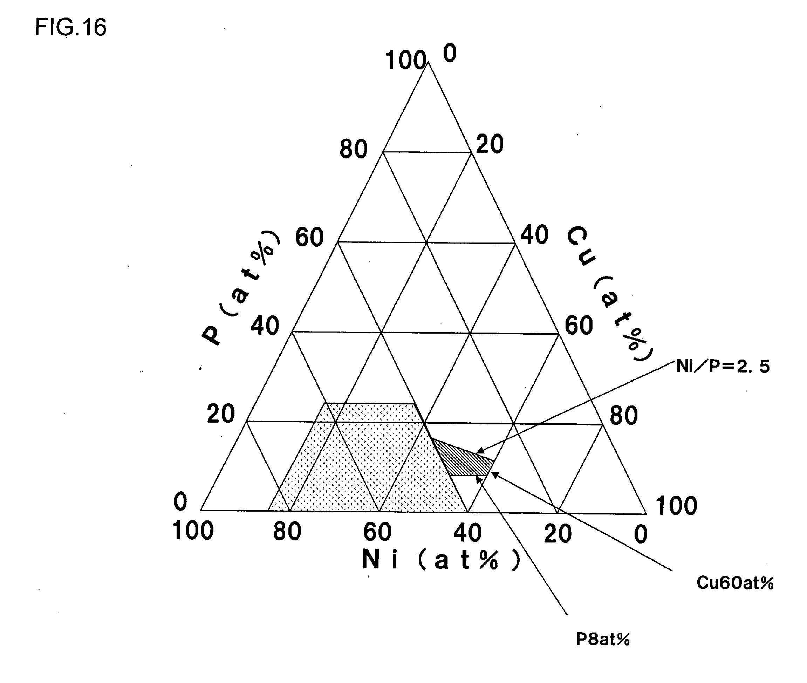

The CuNiP alloy layer (3) contains 44 to 60at% of Cu, 29 to 40at% of Ni, and 8 to 16at% of P with the content of Ni being at least 2.5 times the content of P. UBMs that satisfy the above conditions are those within the composition range surrounded by the rectangle defined by Cu44-Ni40-P16, Cu60-Ni29-P11, Cu60-Ni32-P8, and Cu52-Ni40-P8, as shown in Figure 16. When electrolytic plating or electroless plating, by which a UBM is fabricated, is used to cause P to codeposit in a UBM, the content of Ni is at least approximately 2.5 times the content of P because Ni and P codeposit when the content of P is approximately 40% of the content of Ni or lower.

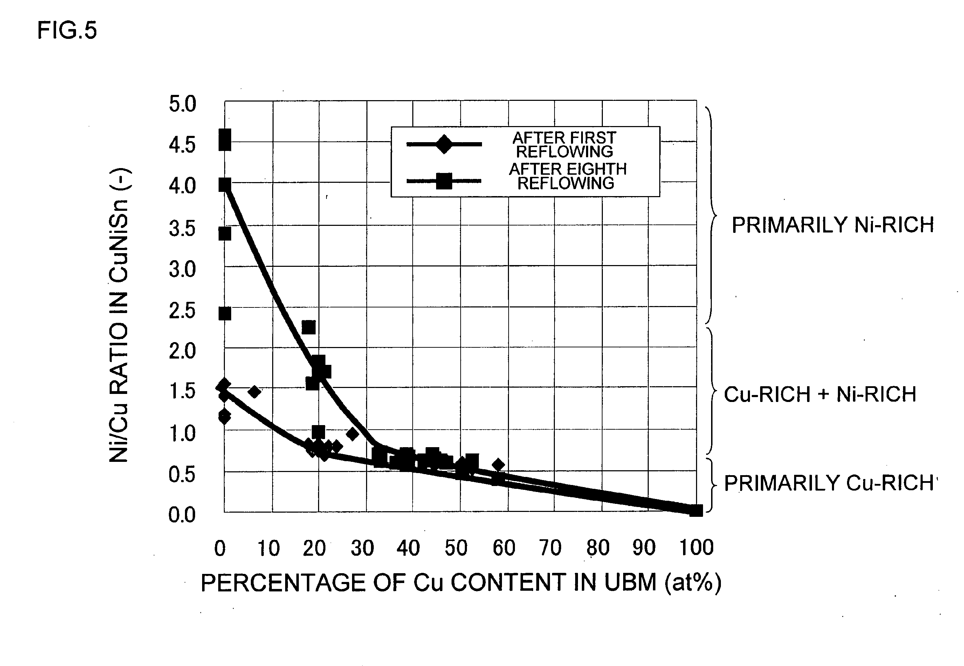

The UBM may be partially formed of a CuNi alloy layer or a CuNiP alloy layer, or may be entirely formed of a CuNi alloy layer or a CuNiP alloy layer, but it is necessary to form a CuNi alloy layer or a CuNiP alloy layer in the UBM at least on the side opposite the side in contact with the electrode pad. The average Ni/Cu ratio in a CuNi alloy layer (1) is preferably 0.67 to 5.7. The average Ni/Cu ratio in a CuNiP alloy layer (2) is preferably 0.60 to 5.5. The average Ni/Cu ratio in a CuNiP alloy layer (3) is preferably 0.48 to 0.91. The average Ni/Cu ratio in a CuNi alloy layer (1) or in a CuNiP alloy layer (2) or (3) changes little after heat treatment, such as a reflow process, and the ratio can be measured by using the same method as the measurement method shown in Figure 5, which will be described later.

The CuNi alloy and the CuNiP alloy used in the UBM 3 are not limited to a binary alloy and a ternary alloy, respectively. The CuNi alloy and the CuNiP alloy can be ternary or quaternary materials or materials containing more elements to which a small amount of Ag, Pd, Sn, Pb, or other elements is added to improve the wettability with solder or to which a small amount of Co, Fe, Pd, Pt, W, Ti, or Cr is added to improve the barrier characteristic. The UBM 3 of the present invention, however, needs to have a composition containing (1) 15 to 60at% of Cu and 40 to 85at% of Ni, (2) 15at% or higher of Cu, 40at% or higher of Ni, and above 0at% and 25at% or lower of P, or (3) 44 to 60at% of Cu, 29 to 40at% of Ni, and 8 to 16at% of P with the content of Ni being at least 2.5 times the content of P.

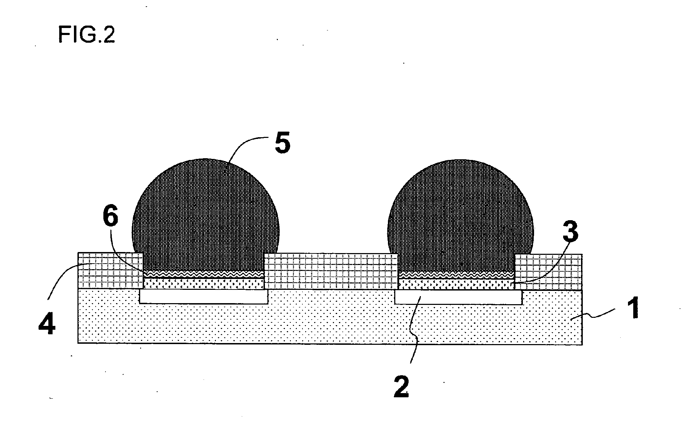

A solder bump 5 is placed on the UBM 3 shown in Figure 1 with a CuNiSn alloy layer 6 therebetween, as shown in Figure 2. The solder bump 5 is primarily made of Sn, such as SnPb, SnAg, SnCu, SnAgCu, Snln, SnZn, and SnZnBi. The average Ni/Cu ratio in the CuNiSn alloy layer 6 present at the bonding interface is 2.3 or lower. After a solder bump material is placed on the UBM, the CuNiSn alloy layer is formed between the UBM and the solder bump during the formation of the solder bump. The average Ni/Cu ratio therefore represents the average Ni/Cu ratio in the CuNiSn alloy layer after the solder bump is formed on the UBM and the CuNiSn alloy layer is formed.

The CuNiSn alloy layer is made of an alloy containing Cu-rich (Cu, Ni)₆Sn₅ or Cu-rich (Cu, Ni)₃Sn. Part of the layer sometimes contains Ni-rich (Ni, Cu)₃Sn₄ or Ni-rich (Ni, Cu)₃Sn₄. Even when such an Ni-rich alloy is contained, the average Ni/Cu ratio in the CuNiSn alloy layer 6 is 2.3 or lower.

Although actual composition ratios of the above alloys may slightly shift from those of the exact intermetallic compounds, SEM-EDX-based composition analysis shows the following results:
- Cu-rich (Cu, Ni)₆Sn₅: a CuNiSn alloy containing 24 to 55at% of Cu, 0 to 24at% of Ni, and 40 to 50at% of Sn
- Cu-rich (Cu, Ni)₃Sn: a CuNiSn alloy containing 35 to 75at% of Cu, 0 to 35at% of Ni, and 20 to 30at% of Sn
- Ni-rich (Ni, Cu)₃Sn₄: a CuNiSn alloy containing 20 to 45at% of Ni, 0 to 20at% of Cu, and 55 to 65at% of Sn

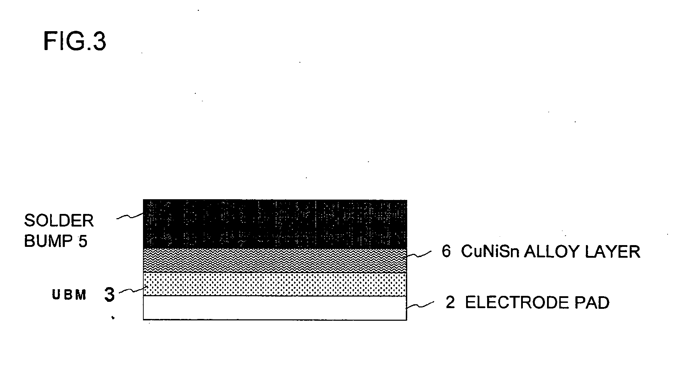

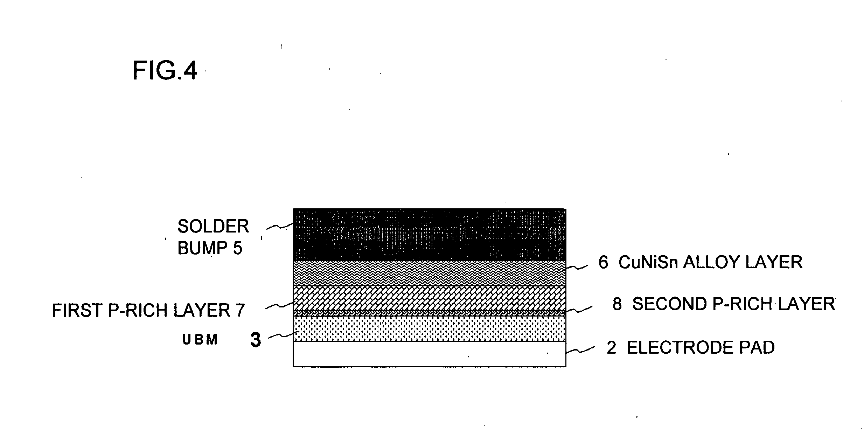

Figure 3 is an enlarged cross-sectional view of a region close to the interface where the UBM 3 made of a CuNi alloy layer (1), the CuNiSn alloy layer, and the solder bump are bonded. Figure 4 is an enlarged cross-sectional view of a region close to the interface where the UBM 3 made of a CuNiP alloy layer (2) or (3), the CuNiSn alloy layer, and the solder bump are bonded.

As shown in Figure 3, when a CuNi alloy layer (1) is used as the UBM 3, the CuNiSn alloy layer 6 is formed between the UBM 3 and the solder bump 5. Since the UBM 3 does not contain P, the composition of the CuNiSn alloy layer 6 will not change after the layers have been formed.

On the other hand, as shown in Figure 4, when the UBM 3 is made of a CuNiP alloy (2) or (3), a first P-rich layer 7 primarily made of an NiSnP alloy or an NiCuSnP alloy is formed between the CuNiSn alloy layer 6 and the UBM 3. The first P-rich layer 7 is formed by interdiffusion of Cu and Sn and has a slightly higher content of P than that in the surrounding region. The composition of the first P-rich layer 7 varies, but typically contains approximately 30 to 50at% of Ni, 20 to 40at% of Sn, 10 to 30at% of P, and 5 to 15at% of Cu.

A second P-rich layer 8 made of a P-rich NiP alloy (an alloy primarily made of Ni₃P), CuNiP alloy, or other P-rich alloys is formed between the first P-rich layer 7 and the UBM 3. The CuNiP alloy in the second P-rich layer contains 45 to 80at% of Ni, 0 to 30at% of Cu, and 15 to 30at% of P.

The present invention is characterized in that the second P-rich layer 8 is significantly thinner than in a case where a conventional UBM made of NiP is used. The P-rich layer formed when a CuNiP alloy (2) or (3) of the present invention is used includes the first P-rich layer 7 and the second P-rich layer 8, and these P-rich layers have slightly larger concentration values of P than those in the UBM and the solder bump. Advantageous effects of the present invention will be described below.

### (a) Prevention of growth of Ni-rich intermetallic compound

In the present invention, (1) a CuNi alloy layer contains 15 to 60at% of Cu and 40 to 85at% of Ni, (2) a CuNiP alloy layer contains 15tat% or higher of Cu, 40at% or higher of Ni, and above 0at% and 25at% or lower of P, or (3) a CuNiP alloy layer contains 44 to 60at% of Cu, 29 to 40at% of Ni, and 8 to 16at% of P with the content of Ni being at least 2.5 times the content of P. It is therefore possible to greatly suppress the generation of alloy layers made of Ni-rich (Ni, Cu)₃Sn₄ and Ni₃Sn₄ after the use in a high-temperature environment.

It is further possible to facilitate the formation of a Cu-rich (Cu, Ni)₆Sn₅ alloy layer and improve the bonding strength between the UBM and the solder bump after the use at high temperatures, because Cu preferentially diffuses into the solder bump as compared to Ni when a CuNi alloy layer or a CuNiP alloy layer is used as the UBM, that is, because the concentration of Cu in the CuNiSn alloy layer formed at the interface between the UBM and the solder bump becomes high and the formation and growth of a needle-shaped Ni-rich alloy causing decrease in bonding strength is suppressed after the structure is held at high temperatures.

The effect of Cu on suppressing the formation of an Ni-rich CuNiSn alloy is clearly exhibited when a CuNi alloy layer or a CuNiP alloy layer contains a predetermined amount of Cu and the content of Ni is 85at% or lower. When the content of Ni is higher than 85at%, an Ni-rich CuNiSn alloy is likely formed in the CuNiSn alloy layer formed at the interface between the UBM and the solder bump after repeated reflowing operations. An "Ni-rich CuNiSn alloy" means that the Ni/Cu ratio in the CuNiSn alloy is greater than 1.0, and a "Cu-rich CuNiSn alloy" means that the Ni/Cu ratio in the CuNiSn alloy is smaller than or equal to 1.0.

The decrease in bonding strength due to heat history becomes significant when almost all the CuNiSn alloy layer formed at the interface is made of an Ni-rich CuNiSn alloy, specifically, when the average Ni/Cu ratio in the CuNiSn alloy layer is greater than approximately 2.3. The average Ni/Cu ratio in the CuNiSn alloy layer must therefore be smaller than or equal to 2.3. On the other hand, when an Ni-rich CuNiSn alloy and a Cu-rich CuNiSn alloy are present together (when the average Ni/Cu ratio is within the range of approximately 0.7<Ni/Cu≤2.3), decrease in bonding strength due to fracture of the Ni-rich CuNiSn alloy layer is rarely observed. Further, when only a Cu-rich CuNiSn alloy dominates the CuNiSn alloy layer (when the average Ni/Cu ratio is smaller than or equal to approximately 0.7), bonding strength rarely decreases.

(Relationship between Cu composition in UBM and bonding strength and relationship between average Ni/Cu ratio in CuNiSn alloy layer and bonding strength)
Figure 5 shows a relationship between the average Ni/Cu ratio in the CuNiSn alloy layer and the content of Cu in the UBM when the UBM is made of a CuNiP alloy and the solder bump is made of SnAgCu by way of example. In Figure 5, sample preparation and characteristic measurement were made as follows.

### Sample preparation method

A plating solution containing Ni ions, Cu ions, and sodium hypophosphite was used to perform electroless plating. In this process, the concentrations of the Ni ions, Cu ions, and sodium hypophosphite were changed to form UBMs made of CuNiP alloys containing different amounts of Cu.

### - Reflow conditions

A reflow furnace was used to melt an SnAgCu (=96.5:3:0.5) solder bump immobilized on the UBM by using a flux in a nitrogen atmosphere at 300°C at the maximum and bond the solder bump to the UBM. When a sample that has undergone an eighth reflowing operation is prepared, the reflowing operation was repeated eight times.

### - Method for measuring the content of Cu in UBM

The interface where the solder bump is bonded to UBM was cut to be exposed. The composition analysis by SEM-EDS was performed on the UBM, and the content of Cu was measured.

### - Measurement of average Ni/Cu ratio in CuNiSn alloy layer

The interface where the solder bump is bonded to UBM was cut to be exposed. The composition analysis of UBM by SEM-EDS was performed on the portion that corresponds to the CuNiSn alloy layer, and the average Ni/Cu ratio was measured. The average Ni/Cu value was calculated and determined by performing SEM-EDX-based area composition analysis on an area of 2 µm in thick by 50 µm in width. However, when the CuNiSn alloy layer was thin and hence the area analysis is difficult to perform, the average Ni/Cu value was determined by using point analysis to make measurement at ten points in the CuNiSn alloy layer and averaging them.

When the reflowing operation was repeated eight times, it was observed that the composition of the CuNiSn layer changed, but the composition of the UBM and solder bump did not change at all or changed little. When the UBM and the solder bump described above were used, a CuNiSn alloy layer is formed at the interface between the UBM and the solder bump. The average Ni/Cu ratio in the CuNiSn alloy layer increases as the content of Cu in the UBM decreases, and the rate of increase in the average Ni/Cu ratio becomes abruptly high when the content of Cu in the UBM reaches approximately 15at%. That is, in the region where the content of Cu in the UBM is higher than or equal to 15at%, the average Ni/Cu ratio is small even in an extremely harsh temperature condition in which the reflowing operation at 300°C at the maximum is repeated eight times, and the rate of change (the slope of each line in Figure 5) in the average Ni/Cu ratio in the CuNiSn alloy layer in response to the change in the content of Cu in the UBM is small. In the region where the content of Cu in the UBM is higher than or equal to 15at%, it is seen that almost no Ni-rich alloy layer that contributes to decrease in bonding strength is formed at the bonding interface between the UBM and the solder bump, but an alloy layer containing a Cu-rich CuNiSn alloy is formed. That is, it is seen that in the region where the content of Cu in the UBM is higher than or equal to 15at%, the average Ni/Cu ratio in the CuNiSn alloy layer that has undergone a first reflowing operation is 2.3 or smaller and so is the average Ni/Cu ratio in the CuNiSn alloy layer that has undergone an eighth reflowing operation.

It is further confirmed that when the average Ni/Cu ratio in the CuNiSn alloy layer present at the bonding interface is smaller than or equal to 0.7, the CuNiSn alloy is made of a Cu-rich CuNiSn alloy; when the average Ni/Cu ratio is greater than 0.7 but smaller than or equal to 2.3, the CuNiSn alloy includes both a Cu-rich CuNiSn alloy and an Ni-rich CuNiSn alloy; and when the average Ni/Cu ratio is greater than 23, almost all the CuNiSn alloy is made of an Ni-rich CuNiSn alloy.

Table 1 shows the relationship between the average Ni/Cu ratio in the CuNiSn alloy layer that has undergone a first reflowing operation and the bump pull strength, and Table 2 shows the same relationship but for the CuNiSn alloy layer that has undergone an eighth reflowing operation. The bump pull strength was measured in the following manner.

### - Method for measuring bump pull strength

For a sample in which a 150-µm diameter SnAgCu (=96.5:3:0.5) solder bump was formed on the UBM having a thickness of approximately 5 µm formed on a 130-µm diameter Al electrode, a cold pull strength tester from Dage Holdings Limited was used to measure the bump pull strength.

**[Table 1]**

| After first reflowing | | | | |
|---|---|---|---|---|
| UBM composition (atomic%) | | | Average Ni/Cu ratio in CuNiSn alloy layer (-) | Bump pull strength (g) |
| Cu | Ni | P | | |
| 44 | 45 | 11 | 0.64 | 155 |
| 39 | 49 | 12 | 0.69 | 133 |
| 33 | 53 | 14 | 0.70 | 151 |
| 20 | 60 | 20 | 0.73 | 154 |
| 19 | 68 | 13 | 0.75 | 110 |
| 18 | 67 | 15 | 0.81 | 133 |
| 6 | 88 | 6 | 1.45 | 125 |
| 0 | 88 | 12 | 1.41 | 116 |

**[Table 2]**

| After eighth reflowing | | | | |
|---|---|---|---|---|
| UBM composition (atomic%) | | | Average Ni/Cu ratio in CuNiSn alloy layer (-) | Bump pull strength (g) |
| Cu | Ni | P | | |
| 44 | 45 | 11 | 0.69 | 142 |
| 39 | 49 | 12 | 0.69 | 131 |
| 33 | 53 | 14 | 0.73 | 155 |
| 20 | 60 | 20 | 0.97 | 130 |
| 19 | 68 | 13 | 1.55 | 120 |
| 18 | 67 | 15 | 2.26 | 119 |
| 6 | 88 | 6 | 4.39 | 71 |
| 0 | 88 | 12 | 3.40 | 83 |

The results shown in Table 1 indicate that after the first reflowing operation, the bump pull strength is 110 g or higher for every UBM composition. However, typical conditions in which the bonding portion is formed are not moderate as those shown in Table 1, but correspond to those after the eighth reflowing operation shown in Table 2. The results shown in Table 2 indicate that when the average Ni/Cu ratio in the CuNiSn alloy layer is smaller than or equal to 2.3, the bump pull strength is 110 g or higher, while when the average Ni/Cu ratio is greater than 2.3 (3.4, 4.39), an Ni-rich CuNiSn alloy begins to dominate the interface between the UBM and the solder bump, and the bump pull strength significantly decreases. It can be indicated that the average Ni/Cu ratio in the CuNiSn alloy tends to increase and hence the bump pull strength tends to decrease as the number of reflowing operations increases. When the content of Cu is higher than or equal to 15at%, however, the rate of increase in the average Ni/Cu ratio in response to the increase in the number of reflowing operations is small, and hence the average Ni/Cu ratio in the CuNiSn alloy layer stays at low values. Therefore, even in a high-temperature environment for an extended period, the amount of decrease in bump pull strength can be small.

As described above, when the average Ni/Cu ratio in the CuNiSn alloy layer is smaller than or equal to 2.3, the CuNiSn alloy layer can contain a Cu-rich CuNiSn alloy, and the bonding strength between the UBM and the solder bump can be maintained at high values as far as the barrier characteristic is intact. Therefore, the optimum composition of a CuNi alloy layer as the UBM contains 15 to 60at% of Cu and 40 to 85at% of Ni, at which the average Ni/Cu ratio in the CuNiSn alloy layer can be maintained at 2.3 or smaller and hence the solder bonding strength will not decrease even when the product is used in a high-temperature environment for an extended period. Similarly, the optimum composition of a CuNiP alloy as the UBM contains (2) 15at% or higher of Cu, 40at or higher of Ni, and above 0at% and 25at% or lower of P, or (3) 44 to 60at% of Cu, 29 to 40at% of Ni, and 8 to 16at% of P with the content of Ni being at least 2.5 times the content of P.

### (b) Suppression of generation and growth of P-rich layer

In a UBM using conventional electroless NiP, there has been a problem of decrease in bonding strength because Ni in the UBM diffuses into the solder bump in the solder bump bonding process, so that a P-rich NiP layer (a layer primarily made of Ni₃P) or the like is formed and the P-rich NiP layer fractures when a stress or impact is applied. In the present invention, however, since the UBM contains a large amount of Cu, which quickly diffuses into the solder, Sn contained in the solder bump diffuses into the UBM easily to some extent. It is therefore possible to greatly suppress the generation of a P-rich NiP layer containing no Sn or other P-rich layers and prevent decrease in bonding strength.

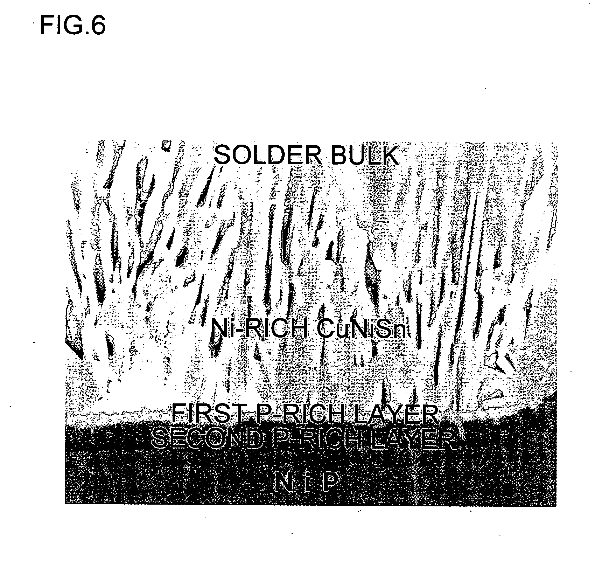

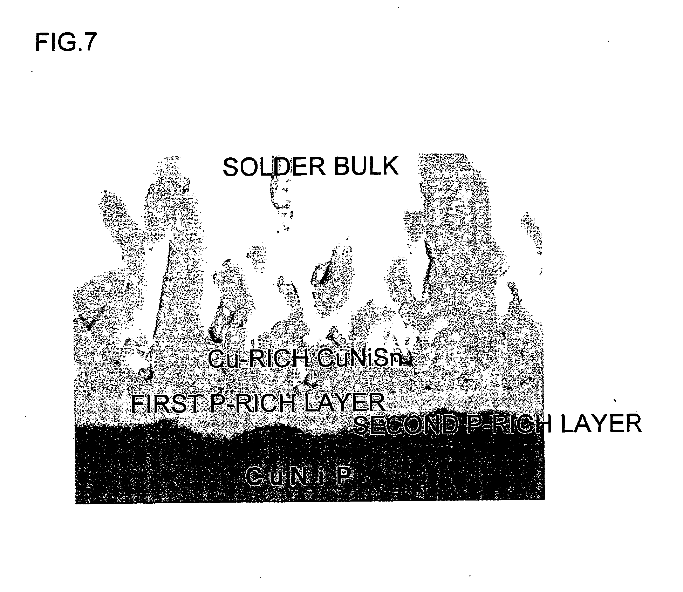

Figure 6 shows a cross-sectional SEM image of the interface between a UBM and an SnAgCu solder bump when a conventional UBM made of a NiP alloy is bonded to an SnAgCu solder bump with a CuNiSn alloy layer therebetween. Figure 7 shows a cross-sectional SEM image of the interface between a UBM and an SnAgCu solder bump when a UBM made of a CuNiP alloy of the present invention containing 15at% or higher of Cu, 40at% or higher of Ni, and above 0at% and 25at% or lower of P is bonded to an SnAgCu solder bump with a CuNiSn alloy layer therebetween.

In Figure 6, a thick P-rich NiP layer (a second P-rich layer) is formed at the interface between the UBM and the solder bump. On the other hand, in the UBM using a CuNiP alloy shown in Figure 7, the P-rich NiP layer (a layer primarily made of Ni₃P: a second P-rich layer) is much thinner than that obtained when the UBM made of an NiP alloy is used, indicating that the generation of the P-rich NiP layer is greatly suppressed. In the UBM using a CuNiP alloy shown in Figure 7, the P-rich NiP layer (a layer primarily made of Ni₃P) is thin, while a thick P-rich NiSnP layer (NiCuSnP, that is, a layer P typically having a composition containing approximately 30 to 50at% of Ni, 20 to 40at% of Sn, 10 to 30at% of P, and 5 to 15at% of Cu: a first P-rich layer) is formed. As a result of a bonding strength evaluation, no fracture mode due to the P-rich layer was observed in a bonding strength test using a CuNiP alloy layer, but only a solder bump fracture mode was observed and the bonding strength did not decrease.

In the present invention, the barrier characteristic after multiple reflowing operations can be enhanced by increasing the concentration of P in the UBM. It is therefore desirable to adjust the content of P in the UBM as appropriate in accordance with applications. Further, for example, even when the content of P is as high as approximately 25at%, but when the UBM contains 15at% or higher of Cu and 40at% or higher of Ni, the generation of a P-rich NiP layer or other layers and the fracture therein are greatly suppressed, thus posing no particular problems.

Further, even when the CuNiP alloy layer (3), which contains 44 to 60at% of Cu, 29 to 40at% of Ni, and 8 to 16at% of P with the content of Ni (based on the number of atoms) being at least 2.5 times the content of P (based on the number of atoms), is formed, the formation of the P-rich NiP layer (second P-rich layer) or other layers can be suppressed as in the case described above. As a result, a high bonding strength between the electrode pad and the solder bump can be maintained.

### (c) Prevention of decrease in bonding strength due to loss of barrier characteristic

### (Relationship between Ni composition in UBM and bonding strength)

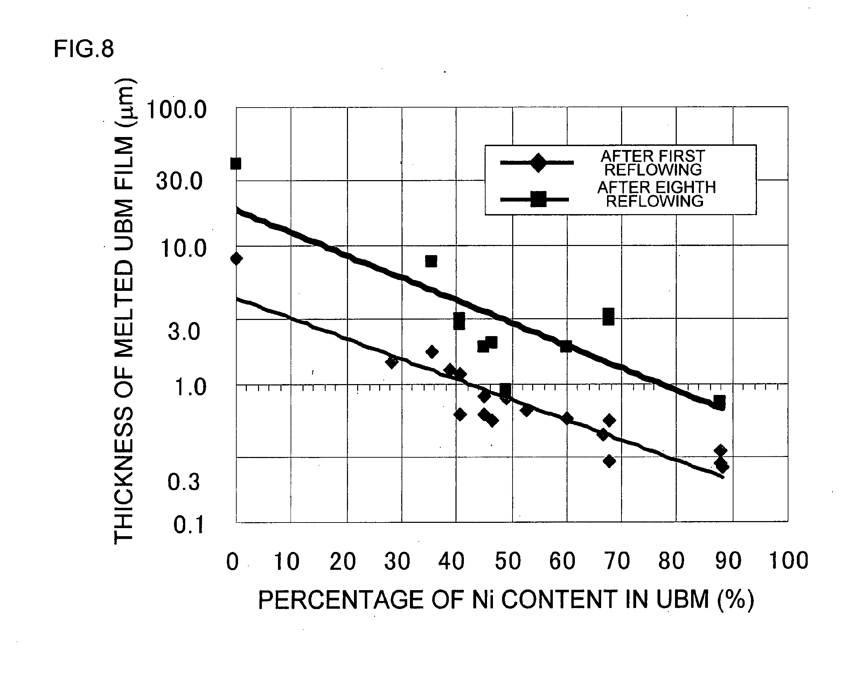

In the present invention, (1) a CuNi alloy layer containing 40 to 85at% of Ni, which has a higher barrier characteristic than Cu, or (2) a CuNiP alloy layer containing 40at% or higher of Ni, which has a higher barrier characteristic than Cu is used in the UBM to ensure a barrier characteristic against solder and prevent decrease in bonding strength after the structure has been held at high temperatures. As an example, Figure 8 shows the barrier characteristic against an SnAgCu solder bump obtained by a UBM made of CuNiP alloy formed in accordance with the present invention.
Figure 8 shows the relationship between the percentage of Ni content in the UBM and the thickness of the melted UBM film after reflowing. The melted film thickness used herein represents the amount of decrease in thickness between the thickness before the formation and the thickness after the formation. The characteristic values in Figure 8 were measured in the following manner.

### - Reflow conditions

A reflow furnace was used to melt an SnAgCu (=96.5:3:0.5) solder bump immobilized on the UBM by using a flux in a nitrogen atmosphere at 300°C at the maximum and bond the solder bump to the UBM. To prepare a sample that has undergone an eighth reflowing operation, the reflowing operation was repeated eight times.

### - Method for measuring the percentage of Ni content in UBM

The interface where the solder bump is bonded to UBM was cut to be exposed. The composition analysis by SEM-EDS was performed on the UBM, and the content of Ni was measured.

### - Method for measuring thickness of melted UBM film

An SEM was used to observe both an electrode pad with a solder bump formed thereon and an electrode pad with no solder bump formed thereon in the same sample. The actual difference in thickness between the two UBM films was measured to determine the thickness of the melted UBM film. The melted film thickness was measured at ten points, and the ten measurements were averaged to determine the melted film thickness.

Figure 8 shows that the thickness of the melted UBM film greatly decreases as the content of Ni, which has an excellent barrier characteristic, in the UBM increases. It has been found that the melted thickness film is smaller than or equal to 5 µm in the region where the content of Ni is higher than or equal to 40at% and the UBM having a practical thickness of 5 µm does not melt even after it has undergone an eighth reflowing operation, whereby sufficient barrier characteristic can be maintained in the range in which a typical electronic device is used.

Table 3 shows the bonding strength after the eighth reflowing operation for UBMs made of a variety of CuNiP alloys. The bump pull strength was measured in the same conditions as those used in Tables 1 and 2. The results shown in Table 3 indicate that UBMs containing Ni lower than 40at% have bump pull strength values as low as 92 g or lower. It is then found that when the film thickness is on the order of 5 µm, the barrier layer fractures and separation of the Al/solder bump interface sharply reduces the bonding strength. On the other hand, it is found that in the UBMs made of a CuNiP alloy containing Ni higher than 40at%, the bump pull strength values are as high as 120 g or higher and the barrier characteristic is maintained, whereby the bonding strength will not sharply decrease unlike the above examples even after storage in a high-temperature environment. It is therefore found that the content of Ni needs to be 40at% or higher (the content of Cu needs to be 60at% or lower) in the UBM made of a CuNi alloy or a CuNiP alloy.

**[Table 3]**

| After eighth reflowing | | | | |
|---|---|---|---|---|
| UBM composition (atomic%) | | | Average Ni/Cu ratio in CuNiSn alloy layer (-) | Bump pull strength (g) |
| Cu | Ni | P | | |
| 62 | 32 | 6 | 0.39 | 28 |
| 55 | 39 | 6 | 0.48 | 92 |
| 44 | 45 | 11 | 0.69 | 142 |
| 39 | 49 | 12 | 0.69 | 131 |
| 33 | 53 | 14 | 0.73 | 155 |
| 20 | 60 | 20 | 0.97 | 130 |
| 19 | 68 | 13 | 1.55 | 120 |

The barrier characteristic in a CuNiP alloy layer depends on not only the content of Ni but also the content of P, and the higher the content of P in the UBM, the better the barrier characteristic. In particular, when the content of P is higher than or equal to 8at%, the barrier characteristic can be maintained even when the content of Cu is slightly high and the content of Ni is slightly low. The content of P needs to therefore be 8at% or higher.

Further investigation conducted by the present inventor has indicated that a P content of 8at% or higher ensures a good barrier characteristic and long-term bonding reliability even when the content of Ni is lower than 40at%. Table 4 shows the thickness of the melted UBM film, the average Ni/Cu ratio, and the bonding strength of a CuNiP alloy having a P content of 8at% or higher and an Ni content of 40at% or lower after an eighth reflowing operation. The bump pull strength was measured in the same conditions as those used in Tables 1 and 2. Samples containing P lower than 8at% shown in Table 3 cannot ensure enough bonding strength after an eighth reflowing operation depending on the composition of the samples, while Table 4 indicates that UBMs containing P higher than or equal to 8at% and Cu lower than or equal to 60at% can be used to maintain the barrier characteristic and a high bonding strength 120 g or more even when the content of Ni is 40at% or lower. It is noted that the content of Ni shown in Table 4 is always at least 2.5 times the content of P.

**[Table 4]**

| After eighth reflowing | | | | | |
|---|---|---|---|---|---|
| UBM composition (atomic%) | | | Thickness of melted UBM film | Average Ni/Cu ratio in CuNiSn alloy layer (-) | Bump pull strength (g) |
| Cu | Ni | P | | | |
| 59 | 33 | 8 | 3.11 | 0.40 | 122 |
| 58 | 31 | 11 | 2.29 | 0.37 | 129 |
| 52 | 39 | 9 | 3.22 | 0.55 | 145 |
| 49 | 37 | 14 | 1.75 | 0.52 | 132 |

### (d) Prevention of decrease in bonding strength due to formation of AuSn alloy

The UBM made of a CuNi alloy (1) or a CuNiP alloy (2) or (3) according to the present invention contains 15at% or higher of Cu, which has good wettability, unlike a conventional UBM made of an Ni or NiP alloy. Therefore, when a solder bump is formed on the UBM made of any of the above alloys with a CuNiSn alloy layer therebetween, the wettability with solder to be provided is similar to that of a UBM formed of a conventional CuNi film that has undergone Au plating or a conventional NiP film that has undergone Au plating. Such an effect of Cu on improving wettability with solder can be provided even when the content of Cu is not higher than or equal to 60at%.

An oxide film is likely formed on the surface of a CuNi alloy layer or a CuNiP alloy layer, and the oxide film is desirably removed by using flux having strong activity. Typical flux can also be used for the removal, and a CuNi alloy layer or a CuNiP alloy layer can be bonded to solder with sufficient strength, because Cu, which has good wettability with solder, is added to the alloy layer. As described above, when no Au treatment is performed on the surface of a CuNi alloy layer or a CuNiP alloy layer, no brittle alloy, such as AuSn, will be formed on the bonding interface after storage at high temperatures. The present inventor has thus found that a UBM made of a CuNi alloy or a CuNiP alloy having a relatively high content of Ni can also maintain a high bonding strength.

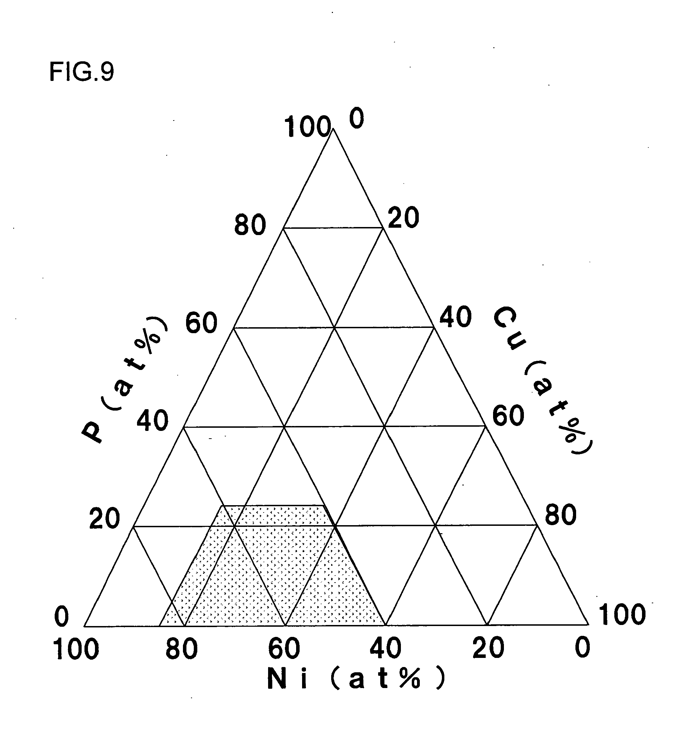

As described above, in the present invention, it is possible to suppress the formation of an Ni-rich CuNiSn alloy, a P-rich NiP layer and CuNiP layer, ensure the barrier characteristic, and maintain a high bonding strength even after use in a high-temperature environment. To this end, preferable composition of CuNiP (2) and (3) is expressed as the region defined by the following ranges: 15at%≤Cu<60at%, 40at%≤Ni<85at%, and 0at%<P≤25at% as shown in Figure 9 and the region defined by the following ranges: 44at%≤Cu≤60at%, 29at%≤Ni≤40at%, and 8at%≤P≤16at% as shown in Figure 16.

### (Second Embodiment)

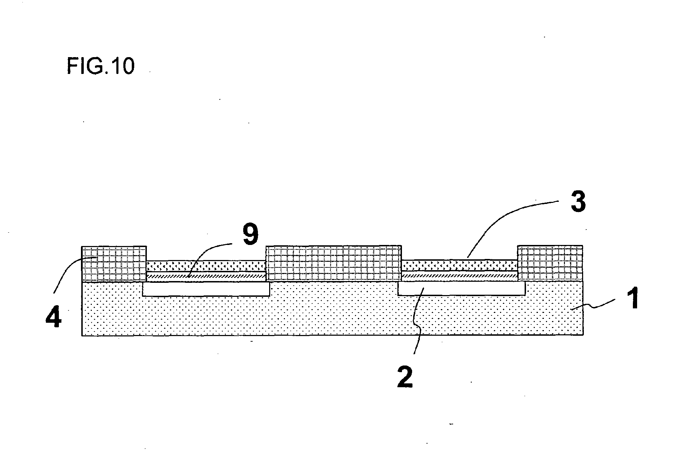

An electric component of the present invention may have, in addition to the structure described above, a structure having two or more layers: an electrode pad 2 made of Al, Cu, Ag, or other elements and a CuNi alloy layer or CuNiP alloy layer 3 with an intermediate layer 9 therebetween, as shown in Figure 10. In this case, the composition of the top barrier metal layer to be connected to a CuNiSn alloy layer needs to be a CuNi alloy or a CuNiP alloy.

Examples of the material of the intermediate layer 9 may include Ni, Cu, Pd, Pt, Fe, Co, Cr, and Ti, and NiP alloys, NiB alloys, and CoP alloys containing any of the above metals. The above alloys in the intermediate layer have the following composition:
- NiP alloy: NiP alloy containing 2 to 25at% of P
- NiB alloy: NiB alloy containing 1 to 10at% of B
- CoP alloy: CoP alloy containing 2 to 25at% of P
One reason of using the intermediate layer 9 is that the adhesion strength between a CuNi or CuNiP alloy layer and the electrode pad 2 can be further improved.

The barrier layer made of a CuNi alloy or a CuNiP alloy may locally fracture during use in extreme conditions. In this case, the electrode pad made of Al or other elements comes into direct contact with a solder bump, and the strength at the direct contact portion becomes nearly zero. In this case, when the intermediate layer 9 made of Ni, an NiB alloy, an NiP alloy, or the like is used, the intermediate layer 9 works as a significantly hard barrier layer, whereby the significant decrease in bonding strength can be reduced to mild decrease in strength.

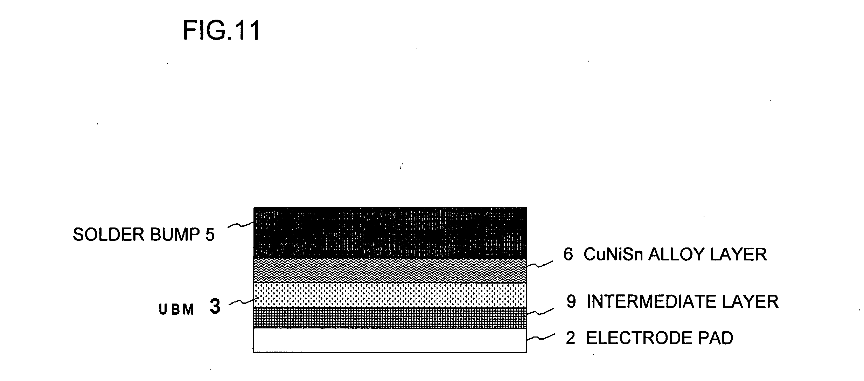

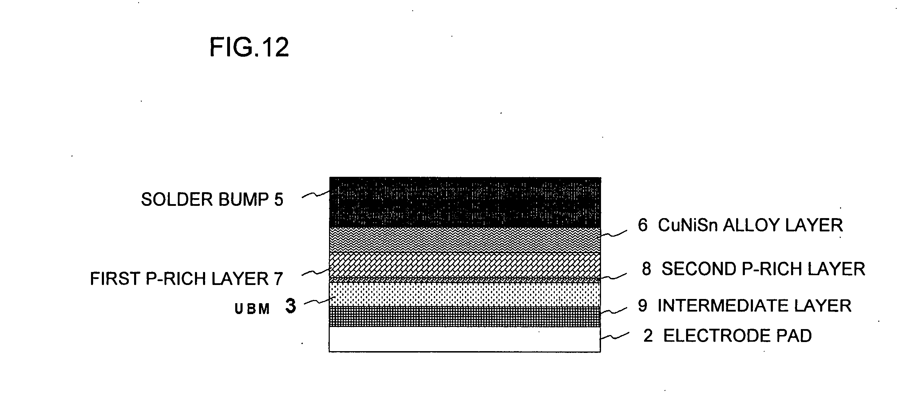

Figures 11 and 12 show cross-sectional structures of electronic components having such intermediate layers connected to solder bumps. Figure 11 shows a case where a UBM made of a CuNi alloy is used, and Figure 12 shows a case where a UBM made of a CuNiP alloy is used.
These structures are the same as those shown in Figures 3 and 4 except that the intermediate layers are added.

### (Third Embodiment)

Electronic components that have been described in the present invention refer to components in general that form an electric circuit, such as those formed on a printed substrate, a flexible substrate, a ceramic substrate, a glass-ceramic substrate, and a semiconductor substrate, as well as chip capacitors and chip resistors.

A semiconductor package of the present invention has electronic members electrically connected via UBMs, solder bumps, and the like. Examples of the electronic member may include substrates (such as mother board substrates, interposer substrates, semiconductor packages, printed substrates, flexible substrates, ceramic substrates, glass-ceramic substrate, and semiconductor substrates) and semiconductor chips (semiconductor elements). Examples of connection between such electronic members may include substrate-to-substrate connection, semiconductor element-to-semiconductor element connection, and substrate-to-semiconductor element connection.

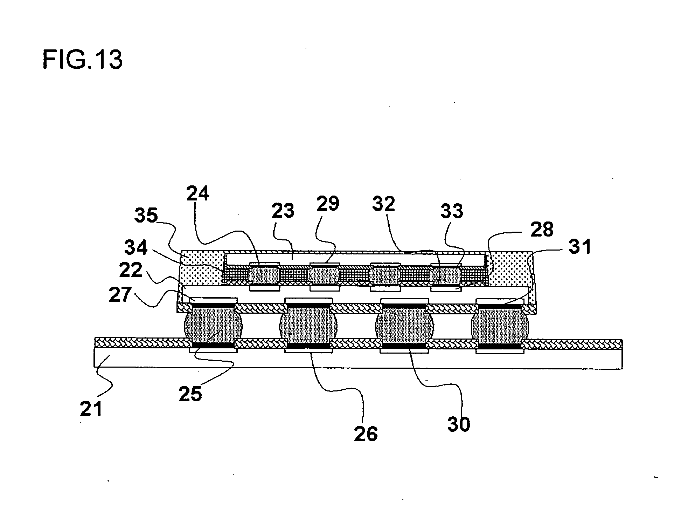

Figure 13 is a cross-sectional view of a semiconductor package mounted on a printed substrate, the semiconductor package comprising two or higher semiconductor elements, in which UBMs of the present invention are formed on the surfaces of electrode pads electrically connected to the semiconductor elements, and the corresponding electrode pads are connected to each other with CuNiSn alloy layers therebetween by using solder bumps.

A conceivable package structure of the semiconductor package shown in Figure 13 uses UBMs 30, 31, 32, and 33, each of which made of a CuNi alloy or a CuNiP alloy, between electrode pads 26, 27, 28, and 29 of a mother board substrate 21, an interposer substrate 22, and a semiconductor chip 23 and solder bumps for primary connection 24 and solder bumps for secondary connection 25, respectively.

The semiconductor package shown in Figure 13 is provided by way of example, and other examples of the semiconductor package of the present invention include a chip-on-chip in which solder bumps connect electrodes of a chip (semiconductor element) to those of another chip, and a package stack in which solder bumps connect electrodes of a package to those of another package. Still another example of the present invention is a chip-on-board in which a chip is connected to a mother board, and in this case, the UBM-solder bump connection structure of the present invention is applied to such a chip-on-board. Further, the UBM and the solder bump connection structure of the present invention are applicable to all electronic devices, such as mobile phones, computers, digital cameras, memory modules, and PDAs.

### Examples

### (First Example)

Examples of the semiconductor package using the connection structure of the present invention will be described below. First, a semiconductor wafer comprising an Al electrode pad thereon undergoes a Pd catalyst process or a zincate process to activate the surface. The semiconductor wafer is then immersed in an electroless CuNiP plating solution held at 80°C for approximately 20 minutes to deposit a CuNiP alloy layer having a thickness of approximately 5 µm on the surface of the semiconductor wafer. When the electrode pad is made of Cu, a Pd catalyst can be used to activate the electrode pad, and an electroless CuNiP alloy layer can be selectively formed on the electrode pad. The electroless CuNiP plating solution contains adequate amounts of Cu ions, Ni ions, sodium hypophosphite, a complexing agent, a pH buffer, a stabilizer, and the like. Adjusting the amounts of Cu ions and Ni ions in the electroless CuNiP plating solution allows formation of a 5-µm-thick UBM made of a CuNiP alloy containing 15at% or higher Cu, 40at% or higher of Ni, and 25at% or lower of P.

Flux is then supplied onto the semiconductor wafer electrode pad on which the UBM has been formed. A ball transfer method is used to place an SnAgCu solder bump, and the UBM is bonded to the solder bump in a reflowing operation. This process allows formation of a CuNiSn alloy layer and a P-rich layer between the solder bump and the UBM, the CuNiSn alloy layer having a thickness of approximately 2 µm and an average Ni/Cu ratio of approximately 0.7. The semiconductor wafer is diced into individual chips, and a mounter is used to align each of the chips with a build-up substrate comprising a UBM made of a CuNiP alloy whose composition is similar to that of the above UBM. The build-up substrate and the semiconductor wafer is placed in a reflow furnace to connect the semiconductor wafer to the build-up substrate.

An underfill resin is injected into the thus fabricated flip connection portion to fabricate a CSP or a BGA. As the method for forming a solder bump, in addition to the solder ball transfer method, solder paste printing, super soldering, the Super Jufit method, electrolytic plating, sputtering, deposition, and the like are applicable.

### (Second Example)

A power feed layer made of, for example, Ti is formed by sputtering on a semiconductor wafer comprising a Cu electrode pad thereon, and then photolithography is used to form a hole in the electrode pad. The semiconductor wafer is immersed in an electrolytic CuNi plating solution containing Cu ions and Ni ions, and current is conducted to deposit a CuNi alloy layer having a thickness of 5 µm on the semiconductor wafer. In this electrolytic plating, the content of Cu and the content of Ni in the electrolytic plating solution are adjusted, as in the electroless plating in the first example, in such a way that desired film composition (Cu: 15 to 60at%, Ni: 40 to 85at%) is obtained. When electrolytic plating is used to form a CuNiP alloy layer, a P source, such as sodium hypophosphite, may be added to the plating solution.

After the CuNi alloy layer has been formed by electrolytic plating, the semiconductor wafer is immersed in a solder plating solution and current is conducted to form a solder bump having a thickness of approximately 100 µm. The resist and the power feed layer are removed, and then the semiconductor wafer is placed in a reflow furnace to form a device with a bonded structure comprising a CuNiSn alloy layer whose average Ni/Cu ratio is 2.3 or lower at the interface between the solder bump and the UBM.

### (Third Example)

A build-up substrate comprising a Cu electrode pad thereon undergoes a Pd catalyst process to activate the surface of the electrode pad. The semiconductor wafer is then immersed in the electroless CuNiP plating solution described in the first example to deposit a CuNiP alloy layer having a thickness of approximately 5 µm. A solder paste is then printed on the electrode, followed by a reflowing operation to form an SnAg solder precoating on the CuNiP alloy layer. A CSP comprising an SnAg solder bump formed thereon is mounted on the printed substrate to fabricate a device comprising a CuNiSn alloy layer and a P-rich layer at the interface between the solder bump and the UBM, the CuNiSn alloy layer having an average Ni/Cu ratio of 2.3 or lower.

### (Fourth Example)

A printed substrate comprising a Cu electrode pad formed thereon, the Cu electrode pad connected to a plating lead wire, is immersed in an electrolytic CuNi plating solution. The plating lead wire is then connected to the cathode and current is conducted to form a CuNi alloy layer film composition (film composition: 15 to 60at% of Cu and 40 to 85at% of Ni) having a thickness of 3 µm only on the Cu electrode pad. An SnAgCu paste is printed on the electrode pad on which the UBM is formed, followed by a reflowing operation to form a solder bump on the UBM. A device with a bonded structure comprising a CuNiSn alloy layer whose average Ni/Cu ratio is 2.3 or lower at the interface between the solder bump and the UBM is thus formed.

### (Fifth Example)

A glass-ceramic substrate comprising an Ag electrode pad formed thereon undergoes a Pd catalyst process to activate the surface of the electrode pad. To first enhance the adhesiveness, the glass-ceramic substrate is immersed in an electroless NiP plating solution to form an NiP alloy having a thickness of approximately 1 µm. A Pd catalyst is used to further activate the NiP plated film, and the glass-ceramic substrate is immersed in an electroless CuNiP plating solution to form a CuNiP alloy layer having a thickness of approximately 3 µm and containing 20at% of Cu, 60at% of Ni, and 20at% of P. The substrate is then immersed in an SnAgCu solder melting tank to form a solder bump on the CuNiP surface. The substrate is then placed in a reflow furnace to form a device with a bonded structure comprising a CuNiSn alloy layer and a P-rich layer at the interface between the solder bump and the UBM, the CuNiSn alloy layer having an average Ni/Cu ratio of 2.3 or lower.

### (Sixth Example)

A semiconductor wafer comprising an Al electrode pad thereon undergoes a zincate process to activate the surface. The semiconductor wafer is then immersed in an electroless CuNiP plating solution held at 80°C for approximately 20 minutes to deposit a CuNiP alloy layer having a thickness of approximately 5 µm on the surface of the semiconductor wafer. In this process, the concentration of sodium hypophosphite in the electroless CuNiP plating solution can be increased (to the order of 0.1 to 1.0 mol/L) to form a 5-µm-thick UBM made of the CuNiP alloy containing 44 to 60at% of Cu, 29 to 40at% of Ni, and 8 to 16at% of P. When electrolytic plating or electroless plating is used to codeposit P in the CuNiP alloy, the amount of deposition of P is only approximately 40% or less of the content of Ni because Ni tends to codeposit along with P. Therefore, the content of Ni in the CuNiP alloy is at least approximately 2.5 times the content of P.

Flux is then supplied onto the semiconductor wafer electrode pad on which the UBM has been formed. A ball transfer method is used to place an SnAgCu solder bump, and the UBM is bonded to the solder bump in a reflowing operation. This process allows formation of a CuNiSn alloy layer and a P-rich layer between the solder bump and the UBM, the CuNiSn alloy layer having a thickness of approximately 3 µm and an average Ni/Cu ratio of approximately 0.4.

The semiconductor wafer is diced into individual chips, and a mounter is used to align each of the chips with a printed wiring substrate comprising a UBM made of a CuNiP alloy with a similar composition. The semiconductor wafer is then placed in a reflow furnace to form a device with a bonded structure comprising a Cu-rich CuNiSn alloy layer at the interface between the solder bump and the UBM.

The composition of the UBM, the composition of the solder bump, the average Ni/Cu ratio in the CuNiSn alloy layer, and the bump pull strength were measured for each of the structures formed in the first to sixth examples. These characteristics were measured by using the same method as those used in Figures 5 and 8. The composition of the solder bump was measured in the same method as that used for the composition of the UBM. Tables 5 and 6 show the results.

**[Table 5]**

| | UBM composition (atomic%) | | | Average Ni/Cu ratio in CuNiSn alloy layer (-) | Composition of solder bump (atomic%) | Bump pull strength (g) |
|---|---|---|---|---|---|---|
| | Cu | Ni | P | | | |
| First example | 39 | 49 | 12 | 0.69 | Sn:Ag:Cu=96.5:3:0.5 | 131 |
| Second example | 42 | 58 | 0 | 0.82 | Sn:Ag=96.5:3.5 | 143 |
| Third example | 36 | 50 | 14 | 0.96 | Sn:Ag=96:4 | 133 |
| Fourth example | 20 | 80 | 0 | 1.13 | Sn:Ag:Cu=95.75:3.5:0.75 | 124 |
| Fifth example | 20 | 60 | 20 | 0.97 | Sn:Ag:Cu=96.5:3:0.5 | 125 |

**[Table 6]**

| | UBM composition (atomic%) | | | Average Ni/Cu ratio in CuNiSn alloy layer (-) | Composition of solder bump (atomic%) | Bump pull strength (g) |
|---|---|---|---|---|---|---|
| | Cu | Ni | P | | | |
| Sixth example | 59 | 33 | 8 | 0.40 | Sn:Ag:Cu=96.5:3:0.5 | 122 |

The results shown in Tables 5 and 6 indicate that as the UBM, (1) a CuNi alloy layer containing 15 to 60at% of Cu and 40 to 85at% of Ni, (2) a CuNiP alloy layer containing 15at% or higher of Cu, 40at% or higher of Ni, and above 0at% and 25at% or lower of P, or (3) a CuNiP alloy layer containing 44 to 60at% of Cu, 29 to 40at% of Ni, and 8 to 16at% of P with the content of Ni being at least 2.5 times the content of P is used to set (4) the average Ni/Cu ratio in a CuNiSn alloy layer to a value lower than or equal to 2.3, whereby a high bump pull strength of 120 g or higher is provided.

## Claims

1. An electronic component comprising:
an electrode pad formed on a substrate or a semiconductor element; and
a barrier metal layer formed to cover the electrode pad,
wherein the barrier metal layer comprises a CuNi alloy layer containing 15 to 60at% of Cu and 40 to 85at% of Ni on the side opposite the electrode pad.

2. The electronic component according to claim 1,
wherein the average Ni/Cu ratio in the CuNi alloy layer ranges from 0.67 to 5.7.

3. An electronic component comprising:
an electrode pad formed on a substrate or a semiconductor element; and
a barrier metal layer formed to cover the electrode pad,
wherein the barrier metal layer comprises a CuNiP alloy layer containing 15at% or higher of Cu, 40at% or higher of Ni, and above 0at% and 25at% or lower of P on the side opposite the electrode pad.

4. The electronic component according to claim 3,
wherein the average Ni/Cu ratio in the CuNiP alloy layer ranges from 0.60 to 5.5.

5. An electronic component comprising:
an electrode pad formed on a substrate or a semiconductor element; and
a barrier metal layer formed to cover the electrode pad,
wherein the barrier metal layer comprises a CuNiP alloy layer on the side opposite the electrode pad, the CuNiP alloy layer containing 44 to 60at% of Cu, 29 to 40at% of Ni, and 8 to 16at% of P with the content of Ni being at least 2.5 times the content of P.

6. The electronic component according to any one of claims 1 to 5,
wherein an intermediate layer is further formed between the electrode pad and the barrier metal layer.

7. The electronic component according to claim 6,
wherein the intermediate layer contains Ni, an NiP alloy, or an NiB alloy.

8. An electronic device,
wherein the electronic device comprises the electronic component according to any one of claims 1 to 7.

9. A semiconductor package comprising:
a plurality of electronic members formed of at least one of a substrate and a semiconductor element;
an electrode pad formed on each of the electronic members;
a barrier metal layer formed to cover the electrode pad;
a CuNiSn alloy layer having an average Ni/Cu ratio of 2.3 or lower formed to cover the barrier metal layer; and
a solder bump formed to electrically connect the electrode pads to each other formed on the different electronic members via the barrier metal layers and the CuNiSn alloy layers,
wherein the barrier metal layer comprises a CuNi alloy layer that is in contact with the CuNiSn alloy layer, the CuNi alloy layer containing 15 to 60at% of Cu and 40 to 85at% of Ni.

10. The semiconductor package according to claim 9,
wherein the average Ni/Cu ratio in the CuNi alloy layer ranges from 0.67 to 5.7.

11. A semiconductor package comprising:
a plurality of electronic members formed of at least one of a substrate and a semiconductor element;
an electrode pad formed on each of the electronic members;
a barrier metal layer formed to cover the electrode pad;
a CuNiSn alloy layer having an average Ni/Cu ratio of 2.3 or lower formed to cover the barrier metal layer;
a P-containing P-rich layer formed between the barrier metal layer and the CuNiSn alloy layer; and
a solder bump formed to electrically connect the electrode pads to each other formed on the different electronic members via the barrier metal layers, the CuNiSn alloy layers, and the P-rich layers,
wherein the barrier metal layer comprises a CuNiP alloy layer that is in contact with the P-rich layer, the CuNiP alloy layer containing 15at% or higher of Cu, 40at% or higher of Ni, and above 0at% and 25at% or lower of P.

12. The semiconductor package according to claim 11,
wherein the average Ni/Cu ratio in the CuNiP alloy layer ranges from 0.60 to 5.5.

13. A semiconductor package comprising:
a plurality of electronic members formed of at least one of a substrate and a semiconductor element;
an electrode pad formed on each of the electronic members;
a barrier metal layer formed to cover the electrode pad;
a CuNiSn alloy layer having an average Ni/Cu ratio of 2.3 or lower formed to cover the barrier metal layer;
a P-containing P-rich layer formed between the barrier metal layer and the CuNiSn alloy layer; and
a solder bump formed to electrically connect the electrode pads to each other formed on the different electronic members via the barrier metal layers, the CuNiSn alloy layers, and the P-rich layers,
wherein the barrier metal layer comprises a CuNiP alloy layer that is in contact with the P-rich layer, the CuNiP alloy layer containing 44 to 60at% of Cu, 29 to 40at% of Ni, and 8 to 16at% of P with the content of Ni being at least 2.5 times the content of P.

14. The semiconductor package according to any one of claims 9 to 13,
wherein an intermediate layer is further formed between the electrode pad and the barrier metal layer.

15. The semiconductor package according to claim 14,
wherein the intermediate layer contains Ni, an NiP alloy, or an NiB alloy.

16. The semiconductor package according to any one of claims 9 to 15,
wherein the region ranging from the barrier metal layer to the solder bump contains no Au.

17. An electronic device,
wherein the electronic device comprises the semiconductor package according to any one of claims 9 to 16.

## Amended claims

### Amended claims under Art. 19.1 PCT

**11.** (Amended) A semiconductor package comprising:
a plurality of electronic members formed of at least one of a substrate and a semiconductor element;
an electrode pad formed on each of the electronic members;
a barrier metal layer formed to cover the electrode pad;
a CuNiSn alloy layer having an average Ni/Cu ratio of 2.3 or lower formed to cover the barrier metal layer;
a P-containing P-rich NiCuSnP layer or a P-containing P-rich NiSnP layer formed between the barrier metal layer and the CuNiSn alloy layer; and
a solder bump formed to electrically connect the electrode pads to each other formed on the different electronic members via the barrier metal layers, the CuNiSn alloy layers, and the P-containing P-rich NiCuSnP layers or the P-containing P-rich NiSnP layers,
wherein the barrier metal layer comprises a CuNiP alloy layer that is in contact with the P-containing P-rich NiCuSnP layer or the P-containing P-rich NiSnP layer, the CuNiP alloy layer containing 15at% or higher of Cu, 40at% or higher of Ni, and above 0at% and 25at% or lower of P.

**13.** (Amended) A semiconductor package comprising:
a plurality of electronic members formed of at least one of a substrate and a semiconductor element;
an electrode pad formed on each of the electronic members;
a barrier metal layer formed to cover the electrode pad;
a CuNiSn alloy layer having an average Ni/Cu ratio of 2.3 or lower formed to cover the barrier metal layer;
a P-containing P-rich NiCuSnP layer or a P-containing P-rich NiSnP layer formed between the barrier metal layer and the CuNiSn alloy layer; and
a solder bump formed to electrically connect the electrode pads to each other formed on the different electronic members via the barrier metal layers, the CuNiSn alloy layers, and the P-containing P-rich NiCuSnP layers or the P-containing P-rich NiSnP layers,
wherein the barrier metal layer comprises a CuNiP alloy layer that is in contact with the P-containing P-rich NiCuSnP layer or the P-containing P-rich NiSnP layer, the CuNiP alloy layer containing 44 to 60at% of Cu, 29 to 40at% of Ni, and 8 to 16at% of P with the content of Ni being at least 2.5 times the content of P.
